# EUROPEAN PATENT SPECIFICATION

(11) **EP 3 299 955 B1**
(45) Date of publication and mention of the grant of the patent: **26.10.2022**
(21) Application number: 16190459.4
(22) Date of filing: 23.09.2016
(51) Int. Cl.: G06F 8/71, G06F 8/36, G06F 8/34

(54) **SYSTEM, METHOD AND COMPUTER PROGRAM PRODUCT FOR CREATING AN ENGINEERING PROJECT IN AN INDUSTRIAL AUTOMATION ENVIRONMENT**
SYSTEM, VERFAHREN UND COMPUTERPROGRAMMPRODUKT ZUR ERZEUGUNG EINES ENGINEERING-PROJEKTS IN EINER INDUSTRIELLEN AUTOMATISIERUNGSUMGEBUNG
SYSTEME, PROCEDE ET PRODUIT-PROGRAMME D'ORDINATEUR DESTINES A CREER UN PROJET D'INGENIERIE DANS UN ENVIRONNEMENT D'AUTOMATISATION INDUSTRIEL

(43) Date of publication of application: 28.03.2018
(73) Proprietor: Siemens Aktiengesellschaft, 80333 München (DE)
(72) Inventor: Uppunda, Prashanth, 560078 Bangalore (IN)
(74) Representative: Isarpatent

(56) References cited:
- EP-A1- 2 963 542
- WO-A1-2007/085619
- GB-A- 2 307 070

## Description

The present disclosure relates to creating engineering in an industrial automation environment, and the invention more particularly relates to a method, an automation engineering system, and a computer program product for creating an engineering project.

Conventional automation engineering systems employed for creating engineering projects, typically involve use of various programmable logic controller (PLC) programming languages such as ladder logic, function block diagrams, structured control language, etc., for development of software for PLCs. These programs are typically written using function blocks also referred to as engineering objects. A common scenario typically existing in the PLC programs is when a function block "A" is dependent on or uses other reusable function block "B", and the function block "B" in-turn uses another reusable function block "C" and so on. In such scenarios, when the function blocks have inter-dependencies, the logic of a PLC program using these inter-dependent function blocks requires accurate use of dependent function blocks in order to achieve successful compilation and execution of the PLC logic developed for a specific customer engineering project.

Moreover, in an industrial automation environment in order to satisfy various needs of factory automation, reusable function blocks typically undergo several changes, each of which is preserved as a version of the respective function block. A user using the engineering application for developing specific logic for the engineering project is required to remember and select particular versions of the function blocks. Due to complex inter-dependency of function blocks, remembering and accessing particular versions of dependent function blocks becomes a cumbersome and time consuming process. Furthermore, use of a specific versioned function block in an engineering project, involves a prior recursive import of each of the dependent function blocks of the respective versions thereby leading to an additional complexity of maintaining a specific order of import of each of the versioned dependent function blocks.

WO 2007/085619 A1 and EP 2 963 542 each describe the storage of versioned objects in a repositoy.

GB 2 307 070 A on the other hand discloses a method and an apparatus for assisting program preparation. A functional relation between components (program modules) is extracted from an already existing program automatically by a computer, or such a functional relation which cannot be extracted is defined by a developer, so that the preparation of a program by combining the components is assisted. A dictionary registration unit reads an object-oriented source code file, analyzes, extracts a component definitions, and extracts from the component definition information a referenced counterpart component name, interface (method) name, and interface definition, and registers the component name, counterpart component name, interface name, and interface definition body in a dictionary. When there is no source code, a component developer inputs the interface information via an input-output device into the dictionary. A program editing processing unit, on the basis of a user's indication, retrieves and displays a list of interfaces between components, and also extracts the interface definition from the dictionary, thereby to assist the user in preparing a program by combining the components.

The object of the present invention is to provide a method, a system and a computer program product which can assist to create an engineering project involving inter-dependent function blocks with minimal time and effort required from a user using the automation engineering system for creating the engineering project. This object is solved by the independent claims and further advantageous embodiments and improvements of the invention are listed in the dependent claims.

The method and system according to the present invention achieve the aforementioned object by obtaining a primary engineering object from a plurality of engineering objects associated with the engineering project from a repository, determining one or more engineering objects from the plurality of engineering objects, that are dependent on the primary engineering object, based on dependency data associated with the primary engineering object, obtaining the dependent one or more engineering objects from the repository, and generating the engineering project using the primary engineering object and the dependent one or more engineering objects, using the automation engineering system.

According to the present invention, a method of creating an engineering project using an automation engineering system is provided. As used herein, "engineering project" refers to a project engineered using the automation engineering system to program efficient integration of and interaction between various engineering objects such as automation components for a specific industrial automation requirement. Also, used herein, engineering objects comprise, for example, PLCs, human machine interfaces (HMIs), PLC function blocks, tag tables, HMI screens etc. According to a preferred embodiment of the present invention, the engineering objects are reusable engineering objects.

The method, according to the present invention, comprises obtaining a primary engineering object from a plurality of engineering objects associated with the engineering project from a repository. As used herein, "primary engineering object" refers to an object or an automation component that a user of the automation engineering system uses for creating the engineering project. According to the present invention, the primary engineering object comprises one or more dependent engineering objects. According to the present invention, each of the dependent engineering objects is a directly dependent engineering object on the primary engineering object or an indirectly dependent engineering object on the primary engineering object. Also, used herein, "repository" refers to a data storage medium employed for storage of the engineering objects. According to the present invention, the repository stores each of the engineering objects according to their respective versions. According to an embodiment of the present invention, the repository is an external storage that the automation engineering system can access either directly or over a communication network. According to another embodiment of the present invention, the repository is configured as cloud based database implemented in a cloud computing environment, where computing resources are delivered as a service over a communication network. As used herein, "cloud computing environment" refers to a processing environment comprising configurable computing physical and logical resources, for example, networks, servers, storage, applications, services, etc., and data distributed over the communication network, for example, the internet. The cloud computing environment provides on-demand network access to a shared pool of the configurable computing physical and logical resources. The communication network is, for example, a wired network, a wireless network, a communication network, or a network formed from any combination of these networks.

The method, according to the present invention, comprises determining one or more engineering objects from the plurality of engineering objects, that are dependent on the primary engineering object, based on dependency data associated with the primary engineering object. As used herein, "dependency data" for a primary engineering object refers to data associated with each of the one or more engineering objects dependent on the primary engineering object. The dependency data for an engineering object comprises, for example, names of each of the dependent engineering objects such as function blocks FB_B, FB_C, etc., versions of each of the dependent engineering objects such as version V2, V1, etc., paths or locations where data specific to each of the dependent engineering objects is stored such as filenames FB_B.xml, FB_C.xml, etc.

According to the present invention determining of the dependent engineering objects comprises obtaining the dependency data associated with the primary engineering object, determining whether there are any engineering objects that are dependent on the primary engineering object based on the dependency data obtained from the repository, obtaining the engineering objects dependent on the primary engineering object using the dependency data, when the dependent engineering objects are determined to be present, and obtaining, from the repository, another primary engineering object from the plurality of engineering objects, when the dependent engineering objects are determined to be absent.

According to the present invention, the dependency data is obtained from the engineering object, the automation engineering system, or a temporary database configured to store the dependency data of each of the engineering objects. According to an embodiment of the present invention, the temporary database resides inside the automation engineering system or external to the automation engineering system accessible either directly or over a communication network.

The method, according to the present invention, comprises obtaining the dependent one or more engineering objects from the repository. According to the present invention, obtaining the dependent one or more engineering objects from the repository comprises obtaining version data associated with the dependent one or more engineering objects, extracting a version of each of the dependent engineering objects based on the version data, determining whether any of the dependent one or more engineering objects of the extracted version are previously obtained from the repository, and obtaining the one or more dependent engineering objects of the extracted version from the repository, when the dependent one or more engineering objects of the extracted version are not previously obtained. The version data comprises, for example, a version of the engineering object and details corresponding to contents for that specific version. According to an embodiment of the present invention, the version data is obtained from the engineering object, the automation engineering system, or a temporary database configured to store the version data of each of the engineering objects. According to another embodiment of the present invention, the dependency data comprises the version data. According to this preferred embodiment of the present invention, determining whether any of the dependent one or more engineering objects of the extracted version are previously obtained from the repository ensures minimal execution redundancy and improved throughput while obtaining the dependent engineering objects.

The method, according to the present invention, comprises generating the engineering project using the primary engineering object and the dependent one or more engineering objects, using the automation engineering system. According to the present invention, generating an engineering project using the obtained primary engineering object and the obtained dependent engineering objects comprises generating a retrieval sequence for obtaining each of the engineering objects from the repository, importing the engineering objects into the automation engineering system based on the generated retrieval sequence, and generating the engineering project using the imported engineering objects. As used herein, "retrieval sequence" refers to an order of importing of the engineering objects, for example, from the temporary database into a processing module of the automation engineering system for creating the engineering project. The retrieval sequence comprises, for example, prioritizing an import of the dependent engineering objects having least or no further dependencies in order to ensure complete and minimally redundant importation of the engineering objects.

According to a preferred embodiment of the present invention, the method comprises performing one or more maintenance actions for each of the engineering objects. In this preferred embodiment of the present invention, the maintenance actions comprise creating the dependency data, updating the dependency data, and storing the dependency data. In this preferred embodiment of the present invention, creation of the dependency data for an engineering object comprises, for example, parsing the engineering object, determining its dependent engineering objects, and storing data associated with the dependent engineering objects as its dependency data in the engineering object, automation engineering system or the temporary database.

According to the present invention, also disclosed herein is an automation engineering system for creating an engineering project. The automation engineering system comprises a non-transitory computer readable storage medium storing computer program instructions defined by modules of the automation engineering system and at least one processor communicatively coupled to the non-transitory computer readable storage medium, executing the defined computer program instructions. The modules of the automation engineering system comprise an object reception module, a dependency determination module, and an engineering generation module. The object reception module is configured to obtain a primary engineering object from a plurality of engineering objects associated with the engineering project from a repository. The dependency determination module is configured to determine one or more engineering objects from the plurality of engineering objects, that are dependent on the primary engineering object, based on dependency data associated with the primary engineering object. The object reception module is further configured to obtain the dependent one or more engineering objects from the repository. The engineering generation module is configured to generate the engineering project using the primary engineering object and the dependent one or more engineering objects.

According to the present invention, also disclosed herein, is a computer program product comprising a non-transitory computer readable storage medium storing computer program codes that comprise instructions executable by at least one processor for performing the method disclosed above for creating an engineering project.

The method, automation engineering system, and the computer program product disclosed herein automatically and accurately determine dependency between function blocks and retrieve exact versions of dependent function blocks in a specific retrieval sequence for creating an engineering project.

The above-mentioned and other features of the invention will now be addressed with reference to the accompanying drawings of the present invention.

The present invention is further described hereinafter with reference to illustrated embodiments shown in the accompanying drawings, in which:
- FIG 1: illustrates an automation engineering system for creating an engineering project.
- FIG 2: is a process flowchart illustrating a method for creating an engineering project using an automation engineering system.
- FIG 3: is a process flowchart illustrating a method for maintaining dependency data in the repository.
- FIG 4: is a block diagram illustrating architecture of a computer system employed by the automation engineering system illustrated in FIG 1 for configuring an engineering project.
- FIG 5: illustrates a dependency diagram of an engineering object that is used by the automation engineering system for creating an engineering project.

Various embodiments are described with reference to the drawings, wherein like reference numerals are used to refer to like elements throughout. In the following description, for the purpose of explanation, numerous specific details are set forth in order to provide thorough understanding of one or more embodiments of the present invention. It may be evident that such embodiments may be practiced without these specific details.

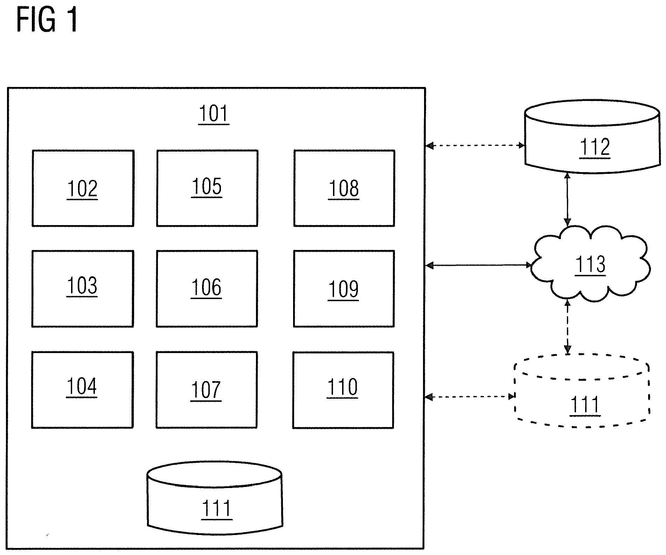

FIG 1 illustrates an automation engineering system 101 for creating an engineering project. The automation engineering system 101, according to the present invention, is installed on and accessible by a user device (not shown), for example, a personal computing device, a workstation, a client device, a network enabled computing device, any other suitable computing equipment, and combinations of multiple pieces of computing equipment. The automation engineering system 101 disclosed herein is in operable communication with a repository 112. The repository 112 is, for example, a version management system such as subversion^{®} of Apache software foundation corporation, and is configured to store each of the versions of the engineering objects. The automation engineering system 101 is downloadable and usable on the user device, is configured as a web based platform, for example, a website hosted on a server or a network of servers, and/or is implemented in the cloud computing environment.

The automation engineering system 101 disclosed herein comprises a non-transitory computer readable storage medium and at least one processor communicatively coupled to the non-transitory computer readable storage medium. As used herein, "non-transitory computer readable storage medium" refers to all computer readable media, for example, non-volatile media, volatile media, and transmission media except for a transitory, propagating signal. The non-transitory computer readable storage medium is configured to store computer program instructions defined by modules, for example, 102, 103, 104, 105, 106, 107, 108, 109, etc., of the automation engineering system 101. The processor is configured to execute the defined computer program instructions. As illustrated in FIG 1, the automation engineering system 101 comprises a graphical user interface (GUI) 110. A user using the user device can access the automation engineering system 101 via the GUI 110. The GUI 110 is, for example, an online web interface, a web based downloadable application interface such as Microsoft^{®} Windows^{®} application, etc. The automation engineering system 101 further comprises an object reception module 102, a dependency determination module 103, and an engineering generation module 104.

The object reception module 102 obtains a primary engineering object from a plurality of engineering objects associated with the engineering project from the repository 112. The dependency determination module 103 determines one or more engineering objects from the plurality of engineering objects that are dependent on the primary engineering object, based on dependency data associated with the primary engineering object. A dependency data reception module 105 of the automation engineering system 101 obtains the dependency data associated with the primary engineering object. The dependency data reception module 105 obtains the dependency data from the engineering object, the automation engineering system 101, or the temporary database 111. The temporary database 111 resides internal to or external to the automation engineering system 101 as illustrated in FIG 1. The dependency determination module 103 determines whether there are any engineering objects that are dependent on the primary engineering object based on the obtained dependency data. The object reception module 102 obtains, from the repository 112, the engineering objects dependent on the primary engineering object using the dependency data, when the dependent engineering objects are determined to be present. The object reception module 102 obtains, from the repository 112, another primary engineering object from the plurality of engineering objects, when the dependent engineering objects are determined to be absent.

The object reception module 102 obtains the dependent one or more engineering objects from the repository 112. For obtaining the dependent engineering objects, a version data reception module 106 of the automation engineering system 101 obtains version data associated with the dependent one or more engineering objects, from the engineering object, the automation engineering system 101, or a temporary database 111 configured to store the version data of each of the engineering objects. For obtaining the dependent engineering objects, a version extraction module 107 of the automation engineering system 101 extracts a version of each of the dependent engineering objects based on the version data. The object reception module 102 determines whether any of the dependent one or more engineering objects of the extracted version are previously obtained from the repository 112 and obtains the one or more dependent engineering objects of the extracted version from the repository 112, when the dependent one or more engineering objects of the extracted version are not previously obtained.

The engineering generation module 104 generates the engineering project using the primary engineering object and the dependent one or more engineering objects. For generating the engineering project, a sequence generation module 108 of the automation engineering system 101 generates a retrieval sequence for obtaining each of the engineering objects from the repository 112, the object reception module 102 imports the engineering objects into the automation engineering system 101 based on the generated retrieval sequence, and the engineering generation module 104 generates the engineering project using the imported engineering objects. A dependency data maintenance module 109 of the automation engineering system 101 performs one or more maintenance actions for each of the engineering objects. The maintenance actions comprise creating the dependency data, updating the dependency data, and storing the dependency data.

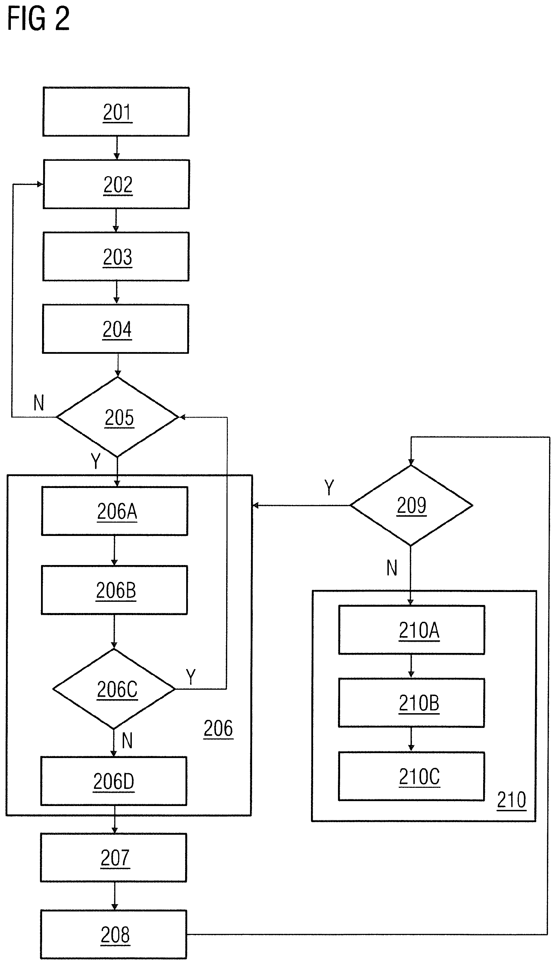

FIG 2 is a process flowchart illustrating a method for creating an engineering project using an automation engineering system 101 illustrated in FIG 1. The method disclosed herein employs the automation engineering system 101 comprising at least one processor configured to execute computer program instructions for creating an engineering project. At step 201, a user accessing the automation engineering system 101 initiates creation of the engineering project, for example, when he/she drags and drops a function block required to create the engineering project onto the graphical user interface (GUI) 110, provided by the automation engineering system 101. At step 202, the automation engineering system 101 obtains a primary engineering object, that is, the function block, from a plurality of engineering objects associated with the engineering project from a repository 112 illustrated in FIG 1. The step of obtaining the engineering object from the repository 112 comprises, fetching a file stored in the repository 112 that corresponds to the primary engineering object. For example, the automation engineering system 101 obtains an extensible markup language (XML) file corresponding to the primary engineering object from the repository 112 and stores the XML file in the temporary database 111 illustrated in FIG 1.

At step 203, the automation engineering system 101 determines one or more engineering objects from the plurality of engineering objects that are dependent on the primary engineering object, based on dependency data associated with the primary engineering object. Each of the dependent one or more engineering objects is a directly dependent engineering object on the primary engineering object or an indirectly dependent engineering object on the primary engineering object. For determining the one or more dependent engineering objects, the automation engineering system 101, at step 204, obtains the dependency data associated with the primary engineering object, from the engineering object, the automation engineering system 101, or a temporary database 111 configured to store the dependency data of each of the engineering objects. The automation engineering system 101 obtains the dependency data from the XML file configured to store the dependency data in one of the sections, for example, a "DocumentInfo" section, of the file. For determining the one or more dependent engineering objects, the automation engineering system 101, at step 205, determines whether there are any engineering objects that are dependent on the primary engineering object based on the obtained dependency data, that is, by determining whether the "DocumentInfo" section of the XML file is empty or populated with data associated with the dependent engineering objects. For determining the one or more dependent engineering objects, the automation engineering system 101, at step 206, obtains from the repository 112, the engineering objects dependent on the primary engineering object using the dependency data, when the dependent engineering objects are determined to be present and when the dependent engineering objects are determined to be absent, the automation engineering system 101 returns control to step 202 and obtains, from the repository 112, another primary engineering object from the plurality of engineering objects. For obtaining the engineering objects dependent on the primary engineering object, at step 206A, the automation engineering system 101 obtains version data associated with the dependent one or more engineering objects from the engineering object, the automation engineering system 101, or a temporary database 111 configured to store the version data of each of the engineering objects. The version data, for example, is stored as a part of the dependency data in the XML file corresponding to the engineering objects. For obtaining the engineering objects dependent on the primary engineering object, at step 206B, the automation engineering system 101 extracts a version of each of the dependent engineering objects based on the version data. For obtaining the engineering objects dependent on the primary engineering object, at step 206C, the automation engineering system 101 determines whether any of the dependent one or more engineering objects of the extracted version are previously obtained from the repository 112, that is, whether an engineering object of the extracted version is obtained and stored already in the temporary database 111. For obtaining the engineering objects dependent on the primary engineering object, at step 206D, the automation engineering system 101 obtains the one or more dependent engineering objects of the extracted version from the repository 112, when the dependent one or more engineering objects of the extracted version are not previously obtained, or else, when the dependent one or more engineering objects of the extracted version are previously obtained, the automation engineering system 101 returns control to step 205 to check whether more dependent engineering objects exist that are to be obtained from the repository 112. At step 207, the automation engineering system 101 stores each obtained dependent engineering object of the extracted version in the temporary database 111.

At step 208, the automation engineering system 101, obtains the dependent one or more engineering objects from the repository 112, that is, the XML files for each of the dependent engineering objects and extracts dependency data for each of the dependent engineering objects. At step 209, the automation engineering system 101 determines whether the dependent engineering objects have any further dependencies, that is, one or more engineering objects exist that are dependent on the dependent engineering object. This dependency information is available in the dependency data of each of the dependent engineering objects. If further dependencies exist, then the automation engineering system 101 returns control to step 206 to obtain the dependent engineering objects. If further dependencies do not exist, then at step 210, the automation engineering system 101 generates an engineering project using the obtained primary engineering object and each of the obtained dependent engineering objects.

For generating the engineering project, at step 210A, the automation engineering system 101 generates a retrieval sequence for obtaining each of the engineering objects from the repository 112. For generating the engineering project, at step 210B, the automation engineering system 101 imports the engineering objects based on the generated retrieval sequence. For generating the engineering project, at step 210C, the automation engineering system 101 generates the engineering project using the imported engineering objects.

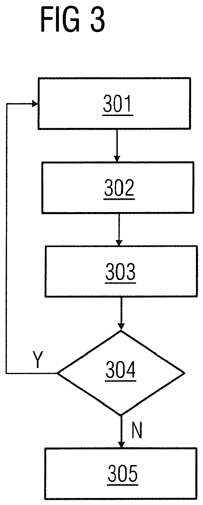

FIG 3 is a process flowchart illustrating a method for maintaining dependency data in the repository 112. The automation engineering system 101 illustrated in FIG 1 performs one or more maintenance actions for each of the engineering objects. The maintenance actions comprise, for example, creating the dependency data, updating the dependency data, and storing the dependency data. As illustrated in FIG 3, the automation engineering system 101, at step 301, stores an engineering object under consideration in a temporary database 111. At step 302, the automation engineering system 101 determines dependency data of the engineering object by parsing its object model. At step 303, the automation engineering system 101 obtains the dependency data stored in the repository 112 for the engineering object under consideration. At step 304, the automation engineering system 101 compares the dependency data obtained by parsing the object model and the dependency data obtained from the repository 112 for discrepancies, if any. At step 305, if discrepancies exist, the automation engineering system 101 stores the dependency data obtained from parsing the object model in a section of an XML file corresponding to the engineering object such as the "DocumentInfo" section, in the repository 112. At step 305, if discrepancies do not exist, the automation engineering system 101 checks for next engineering object for maintenance of dependency data.

The automation engineering system 101 accesses the dependency data thus maintained in the repository 112 while obtaining an engineering object from the repository 112 and determining dependent one or more engineering objects based on the dependency data of the engineering object. It is understood that prior to creation of the engineering project, the repository 112 thus, comprises dependency data, if present any, for each of the engineering objects.

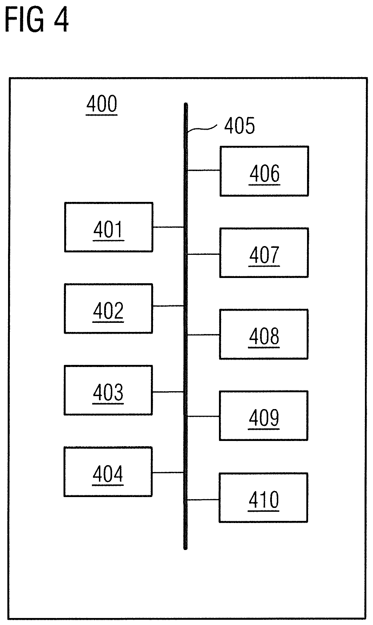

FIG 4 is a block diagram illustrating architecture of a computer system 400 employed by the automation engineering system 101 illustrated in FIG 1, for creating an engineering project using the automation engineering system 101. The automation engineering system 101 employs the architecture of the computer system 400 illustrated in FIG 4. The computer system 400 is programmable using a high level computer programming language. The computer system 400 may be implemented using programmed and purposeful hardware. As illustrated in FIG 4, the computer system 400 comprises a processor 401, a non-transitory computer readable storage medium such as a memory unit 402 for storing programs and data, an input/output (I/O) controller 403, a network interface 404, a data bus 405, a display unit 406, input devices 407, a fixed media drive 408 such as a hard drive, a removable media drive 409 for receiving removable media, output devices 410, etc. The processor 401 refers to any one of microprocessors, central processing unit (CPU) devices, finite state machines, microcontrollers, digital signal processors, an application specific integrated circuit (ASIC), a field-programmable gate array (FPGA), etc., or any combination thereof, capable of executing computer programs or a series of commands, instructions, or state transitions. The processor 401 may also be implemented as a processor set comprising, for example, a general purpose microprocessor and a math or graphics co-processor. The processor 401 is selected, for example, from the Intel^{®} processors, Advanced Micro Devices (AMD^{®}) processors, International Business Machines (IBM^{®}) processors, etc. The automation engineering system 101 disclosed herein is not limited to a computer system 400 employing a processor 401. The computer system 400 may also employ a controller or a microcontroller. The processor 401 executes the modules, for example, 102, 103, 104, 105, 106, 107, 108, 109, etc., of the automation engineering system 101.

The memory unit 402 is used for storing programs, applications, and data. For example, the object reception module 102, the dependency determination module 103, the engineering generation module 104, etc., of the automation engineering system 101 are stored in the memory unit 402 of the computer system 400. The memory unit 402 is, for example, a random access memory (RAM) or another type of dynamic storage device that stores information and instructions for execution by the processor 401. The memory unit 402 also stores temporary variables and other intermediate information used during execution of the instructions by the processor 401. The computer system 400 further comprises a read only memory (ROM) or another type of static storage device that stores static information and instructions for the processor 401. The I/O controller 403 controls input actions and output actions performed by the automation engineering system 101.

The network interface 404 enables connection of the computer system 400 to the communication network 113. For example, the automation engineering system 101 201 connects to the communication network 113 via the network interface 404. In an embodiment, the network interface 404 is provided as an interface card also referred to as a line card. The network interface 404 comprises, for example, interfaces using serial protocols, interfaces using parallel protocols, and Ethernet communication interfaces, interfaces based on wireless communications technology such as satellite technology, radio frequency (RF) technology, near field communication, etc. The data bus 405 permits communications between the modules, for example, 102, 103, 104, 105, 106, 107, 108, 109, 110, etc., of automation engineering system 101.

The display unit 406, via the graphical user interface (GUI 110) 110, displays information such graphical representation of the engineering objects dragged and dropped by the user from a library of automation components, user interface elements such as text fields, buttons, windows, etc., for allowing a user to provide his/her inputs. The display unit 406 comprises, for example, a liquid crystal display, a plasma display, an organic light emitting diode (OLED) based display, etc. The input devices 407 are used for inputting data into the computer system 400. The input devices 407 are, for example, a keyboard such as an alphanumeric keyboard, a touch sensitive display device, and/or any device capable of sensing a tactile input.

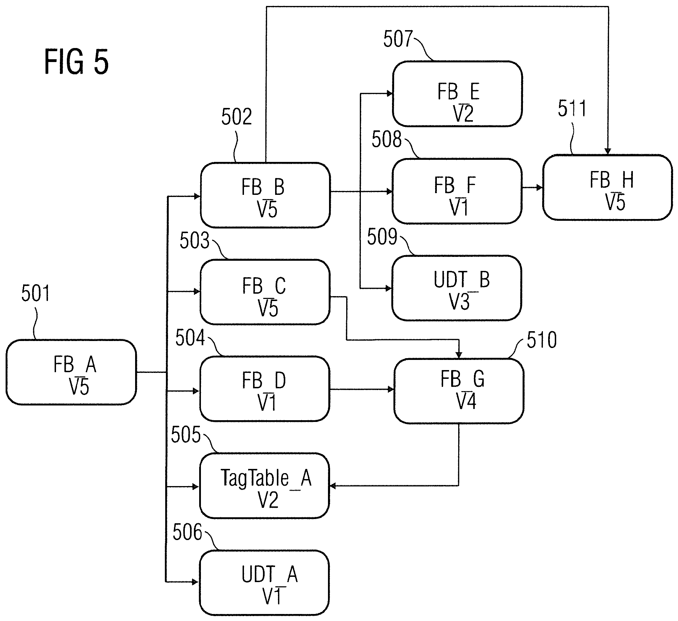

Computer applications and programs are used for operating the computer system 400. The programs are loaded onto the fixed media drive 408 and into the memory unit 402 of the computer system 400 via the removable media drive 409. In an embodiment, the computer applications and programs may be loaded directly via the communication network 113. Computer applications and programs are executed by double clicking a related icon displayed on the display unit 406 using one of the input devices 407. The output devices 410 output the results of operations performed by the automation engineering system 101. For example, the automation engineering system 101 provides graphical representation of the dependency association between various engineering objects illustrated in FIG 5, using the output devices 410.

The processor 401 executes an operating system, for example, the Linux^{®} operating system, the Unix^{®} operating system, any version of the Microsoft^{®} Windows^{®} operating system, the Mac OS of Apple Inc., the IBM^{®} OS/2, etc. The computer system 400 employs the operating system for performing multiple tasks. The operating system is responsible for management and coordination of activities and sharing of resources of the computer system 400. The operating system further manages security of the computer system 400, peripheral devices connected to the computer system 400, and network connections. The operating system employed on the computer system 400 recognizes, for example, inputs provided by the users using one of the input devices 407, the output display, files, and directories stored locally on the fixed media drive 408. The operating system on the computer system 400 executes different programs using the processor 401. The processor 401 and the operating system together define a computer platform for which application programs in high level programming languages are written.

The processor 401 of the computer system 400 employed by the automation engineering system 101 201 retrieves instructions defined by the object reception module 102, the dependency determination module 103, the engineering generation module 104, etc., of the automation engineering system 101 for performing respective functions disclosed in the detailed description of FIG 1. The processor 401 retrieves instructions for executing the modules, for example, 102, 103, 104, 105, 106, 107, 108, 109, etc., of the automation engineering system 101 from the memory unit 402. A program counter determines the location of the instructions in the memory unit 402. The program counter stores a number that identifies the current position in the program of each of the modules, for example, 102, 103, 104, 105, 106, 107, 108, 109, etc., of the automation engineering system 101. The instructions fetched by the processor 401 from the memory unit 402 after being processed are decoded. The instructions are stored in an instruction register in the processor 401. After processing and decoding, the processor 401 executes the instructions, thereby performing one or more processes defined by those instructions.

At the time of execution, the instructions stored in the instruction register are examined to determine the operations to be performed. The processor 401 then performs the specified operations. The operations comprise arithmetic operations and logic operations. The operating system performs multiple routines for performing a number of tasks required to assign the input devices 407, the output devices 410, and memory for execution of the modules, for example, 102, 103, 104, 105, 106, 107, 108, 109, etc., of the automation engineering system 101. The tasks performed by the operating system comprise, for example, assigning memory to the modules, for example, 102, 103, 104, 105, 106, 107, 108, 109, etc., of the automation engineering system 101, and to data used by the automation engineering system 101, moving data between the memory unit 402 and disk units, and handling input/output operations. The operating system performs the tasks on request by the operations and after performing the tasks, the operating system transfers the execution control back to the processor 401. The processor 401 continues the execution to obtain one or more outputs. The outputs of the execution of the modules, for example, 102, 103, 104, 105, 106, 107, 108, 109, etc., of the automation engineering system 101 are displayed to the user on the GUI 110.

For purposes of illustration, the detailed description refers to the automation engineering system 101 being run locally on the computer system 400; however the scope of the present invention is not limited to the automation engineering system 101 being run locally on the computer system 400 via the operating system and the processor 401, but may be extended to run remotely over the communication network 113 by employing a web browser and a remote server, a mobile phone, or other electronic devices. One or more portions of the computer system 400 may be distributed across one or more computer systems (not shown) coupled to the communication network 113.

Disclosed herein is also a computer program product comprising a non-transitory computer readable storage medium that stores computer program codes comprising instructions executable by at least one processor 401 for creating an engineering project using the automation engineering system 101, as disclosed in the present invention. In an embodiment, a single piece of computer program code comprising computer executable instructions performs one or more steps of the method according to the present invention, for creating an engineering project using the automation engineering system 101. The computer program codes comprising computer executable instructions are embodied on the non-transitory computer readable storage medium. The processor 401 of the computer system 400 retrieves these computer executable instructions and executes them. When the computer executable instructions are executed by the processor 401, the computer executable instructions cause the processor 401 to perform the steps of the method for configuring a protection system of a power network.

FIG 5 illustrates a dependency diagram of an engineering object that is used by the automation engineering system 101 for creating an engineering project. Consider an example, where a user of the automation engineering system 101 develops a software code for a programmable logic controller (PLC) using a function block diagram programming language or ladder programming language. Consider in this example, the software code involves programming a PLC for operating a light sensor via a piece of code developed as a sensor management function. Consider the sensor management function is configured to perform specific instructions for which one or more engineering objects such as function blocks, tagtables, user defined data types, etc., are required to be fetched, for example, dragged and dropped, into the automation engineering system 101 from a repository 112 illustrated in FIG. 1. The repository 112 stores one or more versions of each of the engineering objects in form of Extensible Markup Language (XML) files. Each of the engineering objects is programmed to perform a function such as initiation of receipt of data from the light sensor, storing of the received data, generating commands for switch on/off of the light sensor, transmission of generated commands to the light sensor, etc. Consider in this example, the user drags and drops an engineering object 501 representing a function block A of version V3 wherein the engineering object 501 has a plurality of dependent engineering objects such as 502 representing a function block B of version V5, 503 representing a function block C of version V5, 504 representing a function block D of version V1, 505 representing a tag table A of version V2, and 506 representing a user defined data type A of version V1. The engineering object 501 is a primary engineering object that uses its dependent engineering objects 502-511 for its execution.

When the user drags and drops the function block A on the graphical user interface (GUI) 110 provided by the automation engineering system 101, the automation engineering system 101 initiates retrieval of the engineering object 501 from the repository 112. The automation engineering system 101 obtains the XML file FB_A.xml corresponding to the engineering object 501 and maintains the XML file in a temporary database 111 in the automation engineering system 101. A section "DocumentInfo" of the XML file for engineering object 501 comprises dependency data, that is, data of each of the engineering objects 502-506 that are directly dependent on the primary engineering object 501. The automation engineering system 101 parses the "DocumentInfo" section to determine whether there exist any dependent engineering objects 502-506. If yes, then the automation engineering system 101 obtains the dependency data and stores the dependency data in the temporary database 111. The dependency data comprises the object name, the XML file name and the version data, that is, a version number of each dependent engineering object 502-506. The automation engineering system 101, for each of the dependent engineering objects 502-506, obtains corresponding XML files FB_B.xml, FB_C.xml, FB_D.xml, Tagtable_A.xml, and UDT_A.xml, and maintains each of these files in the temporary database 111, if not already present in the temporary database 111. At this point, the temporary database 111 comprises XML files for engineering objects 501-506 and the dependency data for the primary engineering object 501 stored in a format as depicted in table T1 below:

| **FB_A** | | |
|---|---|---|
| Object name | File name | Version |
| FB_B | FB_B.xml | 5 |
| FB_C | FB_C.xml | 5 |
| FB_D | FB_D.xml | 1 |
| Tagtable_A | Tagtable_A.xml | 2 |
| UDT_A | UDT_A.xml | 1 |

The automation engineering system 101 repeats the above steps for each of the XML files stored in the temporary database 111, for engineering objects 502-506. On completing these steps, the temporary database 111 comprises dependency data for engineering objects 502-506 stored in a format as depicted in table T2 below:

| **FB_B** | | |
|---|---|---|
| Object name | File name | Version |
| FB_E | FB_E.xml | 2 |
| FB_F | FB_F.xml | 1 |
| UDT_B | UDT_B.xml | 3 |
| FB_H | FB_H.xml | 5 |
| **FB_C** | | |
| Object name | File name | Version |
| FB_G | FB_G.xml | 4 |

| **FB_D** | | |
|---|---|---|
| Object name | File name | Version |

| **Tagtable_A** | | |
|---|---|---|
| Object name | File name | Version |

| **UDT_A** | | |
|---|---|---|
| Object name | File name | Version |

While processing the XML files FB_D.xml, the automation engineering system 101 does not store the corresponding dependency data in the temporary database 111 since the dependent engineering objects FB_G already exists in the temporary database 111 as a dependent of the function block FB_C. The temporary database 111, at this point, comprises XML files FB_E.xml, FB_F.xml, UDT_B.xml, FB_H.xml, and FB_G.xml respectively for engineering object 507 representing a function block E of version V2, 508 representing a function block F of version V1, 509 representing a user data type B of version V3, 510 representing a function block G of version V4, and 511 representing a function block H of version V5. The automation engineering system 101 repeats the above steps for each of the XML files stored in the temporary database 111, for engineering objects 507-511. On completing these steps, the temporary database 111 comprises dependency data for engineering objects 507-511 stored in a format as depicted in table T3 below:

| **FB_E** | | |
|---|---|---|
| Object name | File name | Version |

| **FB_F** | | |
|---|---|---|
| Object name | File name | Version |

| **UDT_B** | | |
|---|---|---|
| Object name | File name | Version |

| **FB_G** | | |
|---|---|---|
| Object name | File name | Version |

| **FB_H** | | |
|---|---|---|
| Object name | File name | Version |

While processing the XML files FB_F.xml and FB_G.xml, the automation engineering system 101 does not store the corresponding dependency data in the temporary database 111 since the dependent engineering objects FB_H and Tagtable_A already exist in the temporary database 111 as dependents of the function block FB_B and FB_A respectively. On processing each of the dependent engineering objects 502-511 of the engineering object 501, the temporary database 111 comprises XML files for each of the engineering objects 501-511 and the dependency data for each of the engineering objects 501-511 in a format as depicted in tables T1, T2, and T3.

In order to fetch the engineering object 501 into the automation engineering system 101 as specified via the instructions defined in the sensor management function by the user, the automation engineering system 101 now begins importing each of the dependent engineering objects 502-511 of the engineering object 501. The automation engineering system 101 performs this import in a specific retrieval sequence generated by selecting the engineering objects 502-511 that are free of any dependencies as recorded in the temporary database 111, such as engineering objects 504, 505, 506, 507, 508, 509, 510, and 511. The automation engineering system 101 imports the corresponding xml files from the temporary database 111 into the automation engineering system 101. The automation engineering system 101 records the name and version number of each of these engineering objects 504-511 into a dependency log file. The dependency log file is stored in the temporary database 111. The dependency log file comprises data stored in a format depicted in the table T4 below:

| **Function Block** | **Version** |
|---|---|
| FB_D | 1 |
| Tagtable_A | 2 |
| UDT_A | 1 |
| FB_E | 2 |
| FB_F | 1 |
| UDT_B | 3 |
| FB_G | 4 |
| FB_H | 5 |

The automation engineering system 101 sequentially imports each of the remaining XML files FB_B.xml and FB_C.xml for the engineering objects 502 and 503 respectively from the temporary database 111. The automation engineering system 101, for each of the engineering objects 502 and 503, using the corresponding imported XML files, checks whether each of their dependencies are already recorded in the dependency log file. If not, the automation engineering system 101 records the object name and version number of such dependencies in the dependency log file. If yes, then the automation engineering system 101 ends the process.

Thus, when the fetch instruction for the engineering object 501, that is, FB_A of version V3, is given by the user to the automation engineering system 101, the automation engineering system 101 performs a version specific importation of the corresponding dependent engineering objects 502-511 in a sequence 504, 505, 506, 507, 508, 509, 510, 511 followed by 502 and 503 into the automation engineering system 101. This sequential version specific importation enables a non-skilled user of the automation engineering system 101 to efficiently program various modules using engineering objects such as 501 that include multi-level dependencies on other engineering objects 502-511.

It will be readily apparent that the various methods, algorithms, and computer programs disclosed herein may be implemented on computer readable media appropriately programmed for computing devices. As used herein, "computer readable media" refers to non-transitory computer readable media that participate in providing data, for example, instructions that may be read by a computer, a processor or a similar device. Non-transitory computer readable media comprise all computer readable media, for example, non-volatile media, volatile media, and transmission media, except for a transitory, propagating signal.

The computer programs that implement the methods and algorithms disclosed herein may be stored and transmitted using a variety of media, for example, the computer readable media in a number of manners. In an embodiment, hard-wired circuitry or custom hardware may be used in place of, or in combination with, software instructions for implementation of the processes of various embodiments. Therefore, the embodiments are not limited to any specific combination of hardware and software. In general, the computer program codes comprising computer executable instructions may be implemented in any programming language. The computer program codes or software programs may be stored on or in one or more mediums as object code. Various aspects of the method and system disclosed herein may be implemented in a non-programmed environment comprising documents created, for example, in a hypertext markup language (HTML), an extensible markup language (XML), or other format that render aspects of a graphical user interface (GUI) or perform other functions, when viewed in a visual area or a window of a browser program. Various aspects of the method and system disclosed herein may be implemented as programmed elements, or non-programmed elements, or any suitable combination thereof. The computer program product disclosed herein comprises one or more computer program codes for implementing the processes of various embodiments.

Where databases are described such as the temporary database 111 or the repository 112, it will be understood by one of ordinary skill in the art that (i) alternative database structures to those described may be readily employed, and (ii) other memory structures besides databases may be readily employed. Any illustrations or descriptions of any sample databases disclosed herein are illustrative arrangements for stored representations of information. Any number of other arrangements may be employed besides those suggested by tables illustrated in the drawings or elsewhere. Similarly, any illustrated entries of the databases represent exemplary information only; one of ordinary skill in the art will understand that the number and content of the entries can be different from those disclosed herein. Further, despite any depiction of the databases as tables, other formats including relational databases, object-based models, and/or distributed databases may be used to store and manipulate the data types disclosed herein. Likewise, object methods or behaviors of a database can be used to implement various processes such as those disclosed herein. In addition, the databases may, in a known manner, be stored locally or remotely from a device that accesses data in such a database. In embodiments where there are multiple databases in the system, the databases may be integrated to communicate with each other for enabling simultaneous updates of data linked across the databases, when there are any updates to the data in one of the databases.

The present invention can be configured to work in a network environment comprising one or more computers that are in communication with one or more devices via a network. The computers may communicate with the devices directly or indirectly, via a wired medium or a wireless medium such as the Internet, a local area network (LAN), a wide area network (WAN) or the Ethernet, a token ring, or via any appropriate communications mediums or combination of communications mediums. Each of the devices comprises processors, some examples of which are disclosed above. While the operating system may differ depending on the type of computer, the operating system will continue to provide the appropriate communications protocols to establish communication links with the network. Any number and type of machines may be in communication with the computers.

The present invention is not limited to a particular computer system platform, processor, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of systems, and is not limited to any particular distributed architecture, network, or communication protocol.

### Reference Numeral List

- 101: automation engineering system
- 102: object reception module
- 103: dependency determination module
- 104: engineering generation module
- 105: dependency data reception module
- 106: version data reception module
- 107: version extraction module
- 108: sequence generation module
- 109: dependency data maintenance module
- 110: GUI
- 111: temporary database
- 112: repository
- 113: communication network
- 201-210, 301-305: method flow steps
- 400: computer system
- 401: processor
- 402: memory unit
- 403: I/O controller
- 404: network interface
- 405: data bus
- 406: display unit
- 407: input devices
- 408: fixed media drive
- 409: removable media drive
- 410: output devices
- 501: primary engineering object
- 501-511: engineering objects
- 502-511: dependent engineering objects

## Claims

1. A method of creating an engineering project using an automation engineering system (101), the method comprising:
a) obtaining (202) a primary engineering object (501) from a plurality of engineering objects (501-511) associated with the engineering project from a repository (112), comprising:
- retrieving a primary engineering object (501) from the repository (112), obtaining an XML file corresponding to the primary engineering object (501), and maintaining the XML file in a temporary database (111), the XML file comprising dependency data of other engineering objects (502-506) that are directly dependent on the engineering object (501);
b) determining (203) one or more engineering objects (501-511) from the plurality of engineering objects (501-511), that are dependent on the primary engineering object (501), based on dependency data (205) associated with the primary engineering object (501), wherein determining the dependent one or more engineering objects comprises:
- parsing the XML file of the primary engineering object (501) to determine (204) whether there exist any directly dependent engineering objects (502-506), obtaining the dependency data and storing the dependency data in the temporary database (111);
- when directly dependent engineering objects are determined to be absent (205), return to step a),
- when directly dependent engineering objects are determined to be present (205), obtaining (206) the directly dependent engineering objects from the repository (112), by:
- obtaining (206A) version data associated with the dependent one or more engineering objects (502-511);
- extracting (206B) a version of each of the dependent engineering objects (502-511) based on the version data;
- checking (206C) if dependency data is found of an engineering object (510) which already exists in the temporary database (111), in which case dependency data for this engineering object (510) is not stored;
- obtaining (206D) the directly dependent engineering objects (502-506) from the repository (112),
- storing (207) each obtained dependent engineering object of the extracted version in the temporary database (111),
- obtaining (208) the corresponding XML files, and maintaining each of these files in the temporary database (111), stored in a first table which lists the primary engineering object (501; FB_A) associated with its directly dependent engineering objects (502-506) according to object name, file name and version number of the directly dependent engineering object;
- repeating (209) as above the obtaining (206) of indirectly dependent engineering objects (507-511) that depend on the directly dependent engineering objects (502-506), by parsing each of the XML files stored in the temporary database (111),
- such that on completing of these steps, the temporary database (111) comprises dependency data for the directly dependent engineering objects (502-506) stored in a second table which lists each directly dependent engineering object (502-506; FB_B) associated with its respective directly dependent engineering objects (507-511) according to object name, file name and version number of the respective dependent engineering objects (507-511), and the temporary database (111) comprises a third table in which dependent engineering objects (507-510, 511) are contained which are free of any dependency data;
c) generating (210) said engineering project using the primary engineering object (501) and the dependent one or more engineering objects (502-511), using the automation engineering system (101), wherein generating the engineering project using the obtained primary engineering object (501) and the obtained dependent engineering objects (502-511) comprises:
- generating (210A) a retrieval sequence for importing each of the engineering objects (502-511), from the repository (112), into the automation engineering system (101), wherein the retrieval sequence is generated by selecting engineering objects (501-511) free of any dependencies of one or more of the engineering objects (501-511) as recorded in the first, second and third tables of the temporary database (111) and recording them along with their object name and version number in a dependency log file;
- executing a version-specific importation (210B) of the engineering objects (501-511) into the automation engineering system (101) based on the generated retrieval sequence; and following this, importing the dependent engineering objects (502, 503) which have associated dependency data in the first table; and
- generating (210C) the engineering project using the imported engineering objects (501-511).

2. The method according to claim 1, further comprising performing one or more maintenance actions for each of the engineering objects (501-511), wherein the maintenance actions comprise creating the dependency data, updating the dependency data, and storing the dependency data.

3. An automation engineering system (101) for creating an engineering project comprising:
a non-transitory computer readable storage medium storing computer program instructions defined by modules of said automation engineering system (101);
at least one processor (401) communicatively coupled to said non-transitory computer readable storage medium, said at least one processor (401) executing said defined computer program instructions; wherein
said modules of said automation engineering system (101) are adapted to carry out the steps of the method according to one or more of claims 1-2.

4. A computer program product comprising a non-transitory computer readable storage medium, said non-transitory computer readable storage medium storing computer program codes that comprise instructions executable by at least one processor (401) for performing the method according to any of the claims 1-2.

## Patentansprüche

1. Verfahren zur Erstellung eines Engineering-Projekts unter Verwendung eines Automatisierungs-Engineering-Systems (101), wobei das Verfahren umfasst:
a) Erhalten (202) eines primären Engineering-Objekts (501) aus einer mit dem Engineering-Projekt assoziierten Mehrzahl von Engineering-Objekten (501-511) aus einem Repository (112), umfassend:
- Abrufen des primären Engineering-Objekts (501) aus dem Repository (112), Erhalten einer XML-Datei, die dem primären Engineering-Objekt (501) entspricht, und Pflegen der XML-Datei in einer temporären Datenbank (111), wobei die XML-Datei Abhängigkeitsdaten von anderen Engineering-Objekten (502-506) umfasst, die direkt vom Engineering-Objekt (501) abhängen;
b) Bestimmen (203) eines oder mehrerer Engineering-Objekte (501-511) aus der Mehrzahl von Engineering-Objekten (501-511), die vom primären Engineering-Objekt (501) abhängt, basierend auf Abhängigkeitsdaten (205), die mit dem primären Engineering-Objekt (501) assoziiert sind, wobei das Bestimmen des einen oder der abhängigen Engineering-Objekte umfasst:
- Parsen der XML-Datei des primären Engineering-Objekts (501), um zu bestimmen (204), ob es direkt abhängige Engineering-Objekte (502-506) gibt, Erhalten der Abhängigkeitsdaten und Speichern der Abhängigkeitsdaten in der temporären Datenbank (111);
- Zurückkehren zu Schritt a), wenn bestimmt wird, dass keine direkt abhängigen Engineering-Objekte vorhanden sind (205),
- Erhalten (206) der direkt abhängigen Engineering-Objekte aus dem Repository (112), wenn bestimmt wird, dass direkt abhängige Engineering-Objekte vorhanden sind (205), durch:
- Erhalten (206A) von Versionsdaten, die mit dem einen oder den mehreren abhängigen Engineering-Objekten (502-511) assoziiert sind;
- Extrahieren (206B) einer Version eines jeden der abhängigen Engineering-Objekte (502-511) basierend auf den Versionsdaten;
- Prüfen (206C), ob Abhängigkeitsdaten eines Engineering-Objekts (510) gefunden werden, das es in der temporären Datenbank (111) bereits gibt, in welchem Fall die Abhängigkeitsdaten für dieses Engineering-Objekt (510) nicht gespeichert werden;
- Erhalten (206D) der direkt abhängigen Engineering-Objekte (502-506) aus dem Repository (112),
- Speichern (207) jedes erhaltenen abhängigen Engineering-Objekts der extrahierten Version in der temporären Datenbank (111),
- Erhalten (208) der entsprechenden XML-Dateien und Pflegen einer jeden dieser Dateien in der temporären Datenbank (111), die in einer ersten Tabelle gespeichert werden, die das primäre Engineering-Objekt (501; FB_A) in Verbindung mit seinen direkt abhängigen Engineering-Objekten (502-506) gemäß Objektname, Dateiname und Versionsnummer des direkt abhängigen Engineering-Objekts auflistet;
- Wiederholen (209), wie oben, des Erhaltens (206) von indirekt abhängigen Engineering-Objekten (507-511), die von den direkt abhängigen Engineering-Objekten (502-506) abhängen, durch Parsen einer jeden der in der temporären Datenbank (111) gespeicherten XML-Dateien,
- derart, dass nach der Ausführung dieser Schritte die temporäre Datenbank (111) Abhängigkeitsdaten für die direkt abhängigen Engineering-Objekte (502-506) umfasst, die in einer zweiten Tabelle gespeichert sind, die jedes direkt abhängige Engineering-Objekt (502-506; FB_B) in Verbindung mit seinen jeweiligen direkt abhängigen Engineering-Objekten (507-511) gemäß Objektname, Dateiname und Versionsnummer der jeweiligen abhängigen Engineering-Objekte (507-511) auflistet, und die temporäre Datenbank (111) eine dritte Tabelle umfasst, in der abhängige Engineering-Objekte (507-510, 511) enthalten sind, die frei von jeglichen Abhängigkeitsdaten sind;
c) Erzeugen (210) des Engineering-Projekts unter Verwendung des primären Engineering-Objekts (501) und des einen oder der mehreren abhängigen Engineering-Objekte (502-511) unter Verwendung des Automatisierungs-Engineering-Systems (101), wobei das Erzeugen des Engineering-Projekts unter Verwendung des erhaltenen primären Engineering-Objekts (501) und der erhaltenen abhängigen Engineering-Objekte (502-511) umfasst:
- Erzeugen (210A) einer Abrufsequenz zum Importieren eines jeden der Engineering-Objekte (502-511) aus dem Repository (112) in das Automatisierungs-Engineering-System (101), wobei die Abrufsequenz erzeugt wird, indem Engineering-Objekte (501-511), die frei von jeglichen Abhängigkeiten eines oder mehrerer der Engineering-Objekte (501-511) sind, die in der ersten, der zweiten und der dritten Tabelle der temporären Datenbank (111) aufgezeichnet sind, ausgewählt und zusammen mit ihrem Objektnamen und ihrer Versionsnummer in einer Abhängigkeitsprotokolldatei aufgezeichnet werden;
- Ausführen eines versionsspezifischen Imports (210B) der Engineering-Objekte (501-511) in das Automatisierungs-Engineering-System (101) basierend auf der erzeugten Abrufsequenz; und danach Importieren der abhängigen Engineering-Objekte (502, 503), die assoziierte Abhängigkeitsdaten in der ersten Tabelle aufweisen; und
- Erzeugen (210C) des Engineering-Projekts unter Verwendung der importierten Engineering-Objekte (501-511).

2. Verfahren nach Anspruch 1, ferner umfassend ein Durchführen einer oder mehrerer Pflegemaßnahmen für jedes der Engineering-Objekte (501-511), wobei die Pflegemaßnahmen Erstellen der Abhängigkeitsdaten, Aktualisieren der Abhängigkeitsdaten und Speichern der Abhängigkeitsdaten umfassen.

3. Automatisierungs-Engineering-System (101) zum Erstellen eines Engineering-Projekts, umfassend:
ein nichtflüchtiges computerlesbares Speichermedium, das Computerprogrammanweisungen speichert, die durch Module des Automatisierungs-Engineering-Systems (101) definiert sind;
mindestens einen Prozessor (401), der mit dem nichtflüchtigen computerlesbaren Speichermedium kommunikativ verbunden ist, wobei der mindestens eine Prozessor (401) die definierten Computerprogrammanweisungen ausführt; wobei
die Module des Automatisierungs-Engineering-Systems (101) zum Ausführen der Schritte des Verfahrens nach einem oder mehreren der Ansprüche 1 bis 2 ausgelegt sind.

4. Computerprogrammprodukt, umfassend ein nichtflüchtiges computerlesbares Speichermedium, wobei das nichtflüchtige computerlesbare Speichermedium Computerprogrammcodes speichert, die Anweisungen umfassen, die von mindestens einem Prozessor (401) zum Durchführen des Verfahrens nach einem der Ansprüche 1 bis 2 ausgeführt werden können.

## Revendications

1. Procédé de création d'un projet d'ingénierie à l'aide d'un système d'ingénierie d'automatisation (101), le procédé comprenant :
a) l'obtention (202) d'un objet d'ingénierie principal (501) depuis une pluralité d'objets d'ingénierie (501-511) associés au projet d'ingénierie dans un référentiel (112), comprenant :
- la récupération d'un objet d'ingénierie principal (501) dans le référentiel (112), l'obtention d'un fichier XML correspondant à l'objet d'ingénierie principal (501), et la conservation du fichier XML dans une base de données temporaire (111), le fichier XML comprenant des données de dépendance d'autres objets d'ingénierie (502-506) qui sont directement dépendants de l'objet d'ingénierie (501) ;
b) la détermination (203) d'un ou plusieurs objets d'ingénierie (501-511) de la pluralité d'objets d'ingénierie (501-511), qui sont dépendants de l'objet d'ingénierie principal (501), en fonction de données de dépendance (205) associées à l'objet d'ingénierie principal (501), dans lequel la détermination des un ou plusieurs objets d'ingénierie dépendants comprend :
- l'analyse du fichier XML de l'objet d'ingénierie principal (501) pour déterminer (204) s'il existe des objets d'ingénierie directement dépendants (502-506), l'obtention des données de dépendance et le stockage des données de dépendance dans la base de données temporaire (111) ;
- lorsqu'il est déterminé que des objets d'ingénierie directement dépendants sont absents (205), le retour à l'étape a),
- lorsqu'il est déterminé que des objets d'ingénierie directement dépendants sont présents (205), l'obtention (206) des objets d'ingénierie directement dépendants dans le référentiel (112), en :
- obtenant (206A) des données de version associées aux un ou plusieurs objets d'ingénierie dépendants (502-511) ;
- extrayant (206B) une version de chacun des objets d'ingénierie dépendants (502-511) en fonction des données de version ;
- vérifiant (206C) si des données de dépendance d'un objet d'ingénierie (510) qui existent déjà dans la base de données temporaire (111) sont trouvées, auquel cas les données de dépendance pour cet objet d'ingénierie (510) ne sont pas stockées ;
- obtenant (206D) les objets d'ingénierie directement dépendants (502-506) depuis le référentiel (112),
- stockant (207) chaque objet d'ingénierie dépendant obtenu de la version extraite dans la base de données temporaire (111),
- obtenant (208) les fichiers XML correspondants, et en conservant chacun de ces fichiers dans la base de données temporaire (111), stockés dans une première table qui répertorie l'objet d'ingénierie principal (501 ; FB_A) associé à ses objets d'ingénierie directement dépendants (502-506) selon le nom d'objet, le nom de fichier et le numéro de version de l'objet d'ingénierie directement dépendant ;
- la répétition (209) comme ci-dessus de l'obtention (206) d'objets d'ingénierie indirectement dépendants (507-511) qui dépendent des objets d'ingénierie directement dépendants (502-506), en analysant chacun des fichiers XML stockés dans la base de données temporaire (111),
- de telle sorte que suite à la réalisation de ces étapes, la base de données temporaire (111) comprend des données de dépendance pour les objets d'ingénierie directement dépendants (502-506) stockées dans une seconde table qui répertorie chaque objet d'ingénierie directement dépendant (502-506 ; FB_B) associé à ses objets d'ingénierie directement dépendants (507-511) respectifs selon le nom d'objet, le nom de fichier et le numéro de version des objets d'ingénierie dépendants (507-511) respectifs, et la base de données temporaire (111) comprend une troisième table dans laquelle des objets d'ingénierie dépendants (507-510, 511) libres de données de dépendance sont contenus ;
c) la génération (210) dudit projet d'ingénierie à l'aide de l'objet d'ingénierie principal (501) et des un ou plusieurs objets d'ingénierie dépendants (502-511), à l'aide du système d'ingénierie d'automatisation (101), dans lequel la génération du projet d'ingénierie à l'aide de l'objet d'ingénierie principal (501) obtenu et des objets d'ingénierie dépendants (502-511) obtenus comprend :
- la génération (210A) d'une séquence de récupération pour importer chacun des objets d'ingénierie (502-511), depuis le référentiel (112), dans le système d'ingénierie d'automatisation (101), dans lequel la séquence de récupération est générée en sélectionnant des objets d'ingénierie (501-511) libres de dépendances d'un ou plusieurs des objets d'ingénierie (501-511) enregistrés dans les première, seconde et troisième tables de la base de données temporaire (111) et en les enregistrant avec leur nom d'objet et leur numéro de version dans un fichier journal de dépendance ;
- l'exécution d'une importation spécifique à la version (210B) des objets d'ingénierie (501-511) dans le système d'ingénierie d'automatisation (101) en fonction de la séquence de récupération générée ; et suite à cela, l'importation des objets d'ingénierie dépendants (502, 503) qui ont des données de dépendance associées dans la première table ; et
- la génération (210C) du projet d'ingénierie à l'aide des objets d'ingénierie importés (501-511).

2. Procédé selon la revendication 1, comprenant en outre la réalisation d'une ou plusieurs actions de maintenance pour chacun des objets d'ingénierie (501-511), dans lequel les actions de maintenance comprennent la création des données de dépendance, la mise à jour des données de dépendance, et le stockage des données de dépendance.

3. Système d'ingénierie d'automatisation (101) pour créer un projet d'ingénierie comprenant :
un support de stockage lisible par ordinateur non transitoire sur lequel sont stockées des instructions de programme informatique définies par des modules dudit système d'ingénierie d'automatisation (101) ;
au moins un processeur (401) couplé en communication audit support de stockage lisible par ordinateur non transitoire, ledit au moins un processeur (401) exécutant lesdites instructions de programme informatique définies ; dans lequel
lesdits modules dudit système d'ingénierie d'automatisation (101) sont adaptés pour mettre en œuvre les étapes du procédé selon l'une ou plusieurs des revendications 1 à 2.

4. Produit-programme informatique comprenant un support de stockage lisible par ordinateur non transitoire, ledit support de stockage lisible par ordinateur non transitoire stockant des codes de programme informatique qui comprennent des instructions pouvant être exécutées par au moins un processeur (401) pour réaliser le procédé selon l'une quelconque des revendications 1 à 2.
